(19) Europäisches Patentamt
European Patent Office
Office européen des brevets

(11) Veröffentlichungsnummer : **0 440 086 B1**

(12) # EUROPÄISCHE PATENTSCHRIFT

(45) Veröffentlichungstag der Patentschrift :
**25.10.95 Patentblatt 95/43**

(51) Int. Cl.$^6$ : **G03F 7/023,** G03F 7/039

(21) Anmeldenummer : **91100860.5**

(22) Anmeldetag : **24.01.91**

(54) **Strahlungsempfindliches Gemisch, hiermit hergestelltes strahlungsempfindliches Aufzeichnungsmaterial und Verfahren zur Herstellung von Reliefaufzeichnungen.**

(30) Priorität : **02.02.90 DE 4003025**

(43) Veröffentlichungstag der Anmeldung :
**07.08.91 Patentblatt 91/32**

(45) Bekanntmachung des Hinweises auf die Patenterteilung :
**25.10.95 Patentblatt 95/43**

(84) Benannte Vertragsstaaten :
**DE FR GB IT NL**

(56) Entgegenhaltungen :
**EP-A- 0 307 828**
**EP-A- 0 365 318**

(73) Patentinhaber : **HOECHST AKTIENGESELLSCHAFT**
**D-65926 Frankfurt am Main (DE)**

(72) Erfinder : **Elsässer, Andreas, Dr. Dipl.-Chem.**
**Hertastrasse 1b**
**W-6270 Idstein (DE)**
Erfinder : **Frass, Hans Werner, Dr. Dipl.-Chem.**
**Erbsenacker 37**
**W-6200 Wiesbaden (DE)**
Erfinder : **Mohr, Dieter, Dr. Dipl.-Chem.**
**Eaubonner Strasse 8**
**W-6501 Budenheim (DE)**

**EP 0 440 086 B1**

Anmerkung : Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein strahlungsempfindliches Gemisch, ein hiermit hergestelltes Aufzeichnungsmaterial sowie ein Verfahren zur Herstellung von wärme- und chemikalienbeständigen Reliefaufzeichnungen mittels dieses Aufzeichnungsmaterials. Die Erfindung geht aus von einem positiv arbeitenden strahlungs- bzw. lichtempfindlichen Gemisch, das als wesentliche Bestandteile

a) ein in Wasser unlösliches, in wäßrig-alkalischen Lösungen lösliches polymeres Bindemittel und

b) ein 1,2-Chinondiazid und/oder eine Kombination aus

1. einer unter Einwirkung von aktinischer Strahlung starke Säure bildenden Verbindung und
2. einer Verbindung mit mindestens einer spaltbaren C-O-C-Bindung

enthält.

Positiv arbeitende lichtempfindliche Gemische, d. h. Gemische aus den genannten Bestandteilen, deren Kopierschicht an den belichteten Stellen löslich wird, sind bekannt und für vielfältige Anwendungsmöglichkeiten, wie zur Herstellung von Flachdruckplatten oder Photoresists beschrieben.

Ein wesentlicher Teil der Eigenschaften dieser Kopierschichten wird vom mengenmäßigen Hauptbestandteil des strahlungs- bzw. lichtempfindlichen Gemisches, dem Bindemittel, bestimmt. Als Bindemittel für Positiv-Kopierschichten werden praktisch ausschließlich Phenol- oder Kresol-Formaldehyd-Kondensationsprodukte vom Novolaktyp eingesetzt. Für einige Anwendungen von Positiv-Kopierschichten sind jedoch die daraus resultierenden Eigenschaften noch nicht optimal. Dies betrifft insbesondere die Wärmestandfestigkeit im Falle von Photoresistanwendungen und die Höhe der Druckauflagen bei der Verwendung als Flachdruckplatten.

Es hat sich gezeigt, daß durch Susbstitution der Novolake durch Bindemittel mit höherer Glasübergangstemperatur ein generell besseres Eigenschaftsprofil resultiert. So sind eine ganze Reihe von alkalilöslichen Bindemitteln für Positiv-Kopierschichten beschrieben, wie etwa Phenolharze auf Naphtholbasis (US-A 4 551 409), Homo- und Copolymerisate von Vinylphenolen (DE-A- 23 22 230 entsprechend US-A 3 869 292 und DE-A- 34 06 927 entsprechend US-A 4 678 737), Polymerisate der Ester von Acrylsäuren mit Phenolen (JP-OS 76/36 129, EP-A 0 212 440 und EP-A-0 212 439) oder Copolymerisate von Hydroxyphenylmaleinsäureimiden (EP-A-0 187 517).

Bindemittel der genannten Art konnten aber bislang keine praktische Anwendung finden. Ein Grund hierfür ist, daß diese Polymerisate eine wesentliche Forderung , die an Bindemittel von Positiv-Kopierschichten gestellt wird, nicht befriedigend erfüllen, nämlich die der Möglichkeit zur thermischen Selbstvernetzung. Diese Eigenschaft, die bei Novolaken gegeben ist, ist dann von Bedeutung, wenn die Kopierschicht aggressiven Chemikalien standhalten soll.

In der DE-A- 38 20 699 werden Polymerisate auf Basis von Hydroxybenzylacrylamiden beschrieben, die die Forderung nach vernetzbaren, alkalilöslichen Monomerbausteinen erfüllen. Von Nachteil ist jedoch, daß diese Monomeren lediglich in begrenzter Menge in dem Polymerisat enthalten sein können, da andernfalls Lichtempfindlichkeit und Entwicklungsverhalten ungünstig beeinflußt werden.

Weiterhin ist auch bekannt, in die Polymerisate Einheiten einzubauen, die zwar nicht alkali-löslich sind, aber die thermische Vernetzung ermöglichen, wie die in EP-A-0 184 044, entsprechend US-A 4 699 867, beschriebenen Polymerisate mit vernetzungsbefähigten $-CH_2-OR$-Einheiten, wobei R für Wasserstoff, Alkyl- oder Acylgruppen steht. Jedoch beeinträchtigen auch diese Einheiten in den Polymerisaten das Entwicklungsverhalten, wenn sie in den Mengen enthalten sind, wie es für eine sichere thermische Nachhärtung notwendig ist.

Es war daher Aufgabe der Erfindung, ein positiv arbeitendes strahlungsempfindliches Gemisch für ein entsprechendes Aufzeichnungsmaterial zu schaffen, mit dem Flachdruckplatten mit höherer Druckauflagenleistung bzw. Photoresists mit verbessertem Wärmestand bereitgestellt werden können, und das ohne Beeinträchtigung seiner Lichtempfindlichkeit und seines Entwicklungsverhaltens thermisch vernetzbar ist.

Die Lösung dieser Aufgabe geht aus von einem positiv arbeitenden strahlungsempfindlichen Gemisch der eingangs genannten Art und sie ist dadurch gekennzeichnet, daß in dem Gemisch als polymeres Bindemittel ein Polymerisat mit einem Molekulargewicht zwischen 5000 und 100000, einem Gehalt an phenolischen Hydroxylgruppen von etwa 1 bis 15 mmol/g Polymerisat und einem Gehalt an $-CH_{3-n}X_n$ Einheiten von mindestens 0,1 mmol/g Polymerisat, worin X für Halogen und n für 1, 2 oder 3 stehen, vorhanden ist.

Vorzugsweise besitzt das erfindungsgemäße Polymerisat einen Gehalt von etwa 2 bis 10 mmol/g an phenolischen Hydroxylgruppen und einen Gehalt von etwa 0,5 bis 2 mmol/g an $-CH_{3-n}X_n$ Einheiten.

Befinden sich die phenolischen Hydroxylgruppen und die vernetzungsbefähigten $-CH_{3-n}X_n$ Einheiten nicht innerhalb derselben Monomereinheit, so stellt das polymere Bindemittel vorzugsweise ein Copolymerisat dar, das

a) Einheiten der Formel I

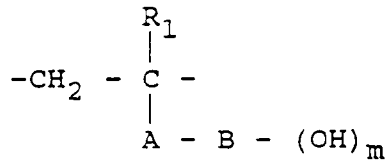

I

worin

$R_1$ Wasserstoff oder $(C_1\text{-}C_4)$-Alkyl,

A eine Einfachbindung oder eine Konfiguration $A_1$ aus der Reihe -K-,

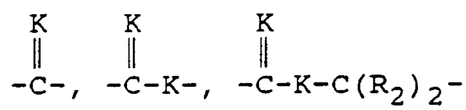

oder $-K\text{-}C(R_2)_2-$

mit

K für -O-, -S- oder $-NR_2-$ und

$R_2$ Wasserstoff oder $(C_1\text{-}C_4)$-Alkyl oder $(C_1\text{-}C_4)$-Alkylen,

B ein gegebenenfalls durch Alkyl, Alkoxy, Halogen oder Aryl substituiertes ein- oder zweikerniges carbocyclisches aromatisches Ringsystem und

m 1 oder 2

bedeuten und

b) Einheiten der allgemeinen Formel II

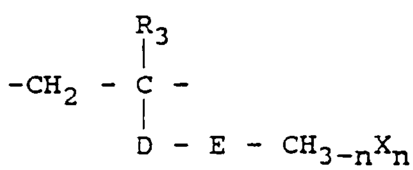

II

worin

$R_3$ Wasserstoff oder $(C_1\text{-}C_4)$-Alkyl,

D eine Einfachbindung, $(C_1\text{-}C_4)$-Alkylen oder die Konfiguration $A_1$,

E eine Einfachbindung, $(C_1\text{-}C_4)$-Alkylen, $(C_1\text{-}C_4)$-Hydroxyalkylen oder B,

X Halogen und

n 1, 2 oder 3

bedeuten, enthält.

Insbesondere enthält das Copolymerisat Einheiten der allgemeinen Formel I, in der

$R_1$ Wasserstoff oder Methyl,

A die Konfiguration $A_1$

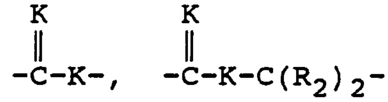

mit

K für -O-, oder $-NR_2-$ und

$R_2$ Wasserstoff,

B Phenyl und

m 1 oder 2

und Einheiten der allgemeinen Formel II, in der

$R_3$ Wasserstoff oder Methyl,

D eine Einfachbindung oder die Konfiguration

-K-,

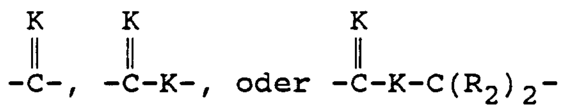

mit

K für -O- oder -$NR_2$- und

$R_2$ Wasserstoff,

E eine Einfachbindung, ($C_1$-$C_2$)-Alkylen, ($C_1$-$C_2$)-Hydroxyalkylen oder Phenyl,

X Chlor oder Brom und

n 1, 2 oder 3

bedeuten.

Befinden sich die phenolischen Hydroxylgruppen und vernetzungsbefähigten -$CH_{3-n}X_n$ Einheiten innerhalb derselben Monomereinheit, so weist das erfindungsgemäße Bindemittel als Homo- oder Copolymerisat Einheiten der Formel III auf:

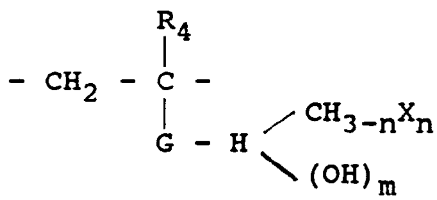

III

worin

$R_4$ Wasserstoff oder ($C_1$-$C_4$) -Alkyl,

G eine Einfachbindung oder ($C_1$-$C_4$)- Alkylen oder eine Konfiguration $G_1$ aus der Reihe

-F-,

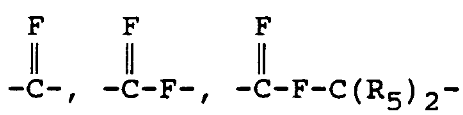

oder -F-C$(R_5)_2$-

mit

F für -O-, -S- oder -$NR_5$- und

$R_5$ Wasserstoff, ($C_1$-$C_4$)-Alkyl oder ($C_1$-$C_4$)-Alkylen,

H ein gegebenenfalls durch Alkyl, Alkoxy, Halogen oder Aryl substituiertes ein- oder zweikerniges carbocyclisches aromatisches Ringsystem,

X Halogen,

m 1 oder 2 und

n 1, 2 oder 3

bedeuten. Insbesondere enthält das Homo- oder Copolymerisat Einheiten der allgemeinen Formel III, in der

$R_4$ Wasserstoff oder Methyl,

G eine Einfachbindung oder die Konfiguration

$G_1$

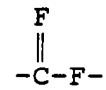

mit F für -O-,

H Phenyl,

X Chlor,

m 1 oder 2 und

n 1

bedeuten.

Es kann von Vorteil sein, wenn das polymere Bindemittel ein Copolymerisat ist, das Einheiten nach den Formeln I, II und III enthält.

Strahlungsempfindliche Gemische sind bevorzugt, in denen als polymeres Bindemittel ein Copolymerisat vorhanden ist, das Einheiten nach den allgemeinen Formeln I und II und/oder III enthält oder daraus besteht.

Homo- oder Copolymerisate entsprechend den Formeln I, II oder III enthalten für X als Halogen Chlor, Brom oder Jod, insbesondere Chlor. Es hat sich gezeigt, daß m und n vorzugsweise gleich 1 sind.

Als ein- oder zweikerniges carbocyclisches, aromatisches Ringsystem seien beispielsweise ein Benzol- oder Naphthalinkern genannt, wovon der Benzolkern bevorzugt ist.

Bevorzugte Monomereinheiten entsprechend Formel I sind beispielsweise:
N-(4-Hydroxyphenyl)methacrylamid, N-(4-Hydroxyphenyl)-acrylamid, o-, m- und p-Hydroxyphenylacrylat oder methacrylat und o-, m- und p-Hydroxystyrol, 4-Hydroxy-3-methylstyrol, 4-Hydroxy-3,5-dimethylbenzylmethacrylat oder -methacrylamid und N-(4-Hydroxyphenyl)maleinimid.

Bevorzugte Beispiele für Monomereinheiten entsprechend Formel II sind:
2-, 3-, 4-Chlormethylstyrol, Chloressigsäurevinylester, Trichloressigsäurevinylester, Chlormethylacrylat oder -methacrylat, 1- oder 2-Chlorethylacrylat oder -methacrylat, N-(2,2,2-Trichlor-2-hydroxyethyl)acrylamid oder -methacrylamid, Chlormethylvinylketon, 3-Chlor-2-hydroxypropylacrylat oder -methacrylat.

Bevorzugte Monomereinheiten der Formel III sind insbesondere die chlormethylierten Derivate der Monomeren entsprechend Formel I.

Neben den beschriebenen Monomereinheiten können die Polymerisate weiterhin Einheiten enthalten, welche zur Einstellung bzw. Anpassung der Polymereigenschaften an spezielle Anwendungen dienen. Im Falle von Trockenresistanwendungen sind eher niedrige Glasübergangstemperaturen der Polymerisate vorteilhaft, welche beispielsweise durch Copolymerisation mit Acryl- oder Methacrylsäurealkylestern oder Alkylvinylethern, wobei die Alkylgruppen 4 - 12 Kohlenstoffatome besitzen, einstellbar sind. Für die Anwendung in Druckplattenkopierschichten sind eher hohe Glasübergangstemperaturen von Vorteil. Diese, eine gute Oleophilie des Kopierschichtfilms und der für die Alkalilöslichkeit wichtige Gehalt an phenolischen Hydroxylgruppen werden erreicht durch Copolymerisation mit Styrol, $\alpha$-Methylstyrol, Vinyltoluol, Phenyl-, Benzyl-, Furfuryl- oder Methylmethacrylat, Acryl- oder Methacrylnitril. Weiterhin ist es möglich, geringe Mengen von bifunktionellen Monomeren oder Monomeren, die in Gegenwart von Säure zu einer thermischen Vernetzungsreaktion führen, beispielsweise solche mit seitenständigen $-CH_2OR$-Gruppen, entsprechend EP 0 184 044, oder Monomere mit Epoxideinheiten, in die Bindemittel einzupolymerisieren.

Es hat sich gezeigt, daß zur thermischen Vernetzung die Anwesenheit an $-CH_{3-n}X_n$-Einheiten von mindestens 0,1 mmol/g Polymerisat ausreicht. Um eine günstige Durchhärtung zu erreichen hat sich ein Gehalt von etwa 0,5 bis 2, insbesondere von etwa 1 mmol/g Polymerisat als günstig erwiesen. Im Bedarfsfall können auch höhere Gehalte vorliegen, ohne daß andere Eigenschaften nachteilig beeinflußt werden.

Die Herstellung der erfindungsgemäßen Polymerisate erfolgt durch Homo- oder Copolymerisation von Monomeren, welche vernetzungsbefähigte $-CH_{3-n}X_n$ Einheiten enthalten und/oder durch nachträgliche Einführung der $-CH_{3-n}X_n$ Einheiten in die Polymerisate. Insbesondere im Falle der Chlormethylgruppen gelingt dies auf einfache und bekannte Weise durch Umsetzung mit Chlormethylalkylethern in Gegenwart von Säure.

Die Homopolymerisation der Monomeren mit Einheiten der Formeln I bis III oder deren Copolymerisation mit anderen Monomeren läßt sich nach konventionellen Methoden durchführen, beispielsweise in Gegenwart eines Polymerisationsinitiators wie Azo-bis-isobuttersäurenitril in organischen Lösungsmitteln wie Methylethylketon oder Tetrahydrofuran bei erhöhten Temperaturen während eines Zeitraums von 1 bis 20 Stunden. Daneben ist aber auch eine Supensions-, Emulsions- oder Massepolymerisation möglich, die auch durch Strahlung, Hitze oder ionische Initiatoren ausgelöst werden kann.

Zur Herstellung der erfindungsgemäßen Gemische wird das beschriebene Bindemittel, das in Mengen im Bereich von 10 bis 95 Gewichtsprozent, bezogen auf nichtflüchtige Bestandteile des Gemisches vorhanden ist, kombiniert mit lichtempfindlichen Verbindungen bzw. Gemischen, deren Löslichkeit in einer wäßrig-alkalischen Entwicklerlösung mit dem Belichten erhöht wird. Hierzu gehören 1,2-Chinondiazide und Gemische von photolytischen Säurespendern mit säurespaltbaren Verbindungen.

Als 1,2-Chinondiazide werden bevorzugt Naphthochinon-1,2-diazid-(2)-4-oder -5-sulfonsäureester oder -amide verwendet. Von diesen werden die Ester, insbesondere die der 5-Sulfonsäuren, bevorzugt. Geeignete Verbindungen dieser Art sind bekannt und zum Beispiel in der DE-A 938 233, entsprechend GB-B 739,654, beschrieben.

Die Menge von o-Chinondiazidverbindungen beträgt im allgemeinen 3 bis 50, bevorzugt 7 bis 35 Gewichtsprozent, bezogen auf die nichtflüchtigen Anteile des Gemisches.

Es ist auch möglich die 1,2-Chinondiazidverbindungen in Form ihrer Ester mit den erfindungsgemäßgen Polymerisaten einzusetzen.

Die Veresterung der entsprechenden 1,2-Chinondiazidsäurechloride mit den Hydroxylgruppen der zugrunde liegenden Polymerisate erfolgt nach den in der Literatur bekannten Verfahren (DE-A 25 07 548, entsprechend US-A 4 139 384).

Auch Materialien auf Basis säurespaltbarer Verbindungen lassen sich mit gutem Effekt in dem erfindungsgemäßen Gemisch einsetzen. Als durch Säure spaltbare Verbindungen sind in erster Linie zu nennen:

a) solche mit mindestens einer Orthocarbonsäureester- und bzw. oder Carbonsäureamidacetalgruppierung, wobei die Verbindungen auch polymeren Charakter haben und die genannten Gruppierungen als verknüpfende Elemente in der Hauptkette oder als seitenständige Substituenten auftreten können,

b) Oligomer- oder Polymerverbindungen mit wiederkehrenden Acetal-und/oder Ketalgruppierungen in der Hauptkette und

c) Verbindungen mit mindestens einer Enolether- oder N-Acylaminocarbonatgruppierung.

Durch Säure spaltbare Verbindungen des Typs a) als Komponenten strahlungsempfindlicher Gemische sind in der EP-A 0 022 571, entsprechend US-A 4 311 782, ausführlich beschrieben; Gemische, die Verbindungen des Typs b) enthalten, sind in der DE-C 23 06 248, entsprechend US-A 3 779 778, und in der DE-C 27 18 254 und US-A 4 189 323 beschrieben; Verbindungen des Typs c) werden in EP-A 0 006 627, entsprechend US-A 4 248 957 offenbart.

Die Art und Menge der spaltbaren Verbindung kann je nach Anwendungsart verschieden sein. Bevorzugt werden Anteile zwischen 5 und 70 Gewichtsprozent, insbesondere 5-40 Gewichtsprozent, bezogen auf die nichtflüchtigen Anteile des Gemisches eingesetzt.

Als strahlungsempfindliche Komponenten, die beim Belichten starke Säuren bilden, sind eine große Anzahl von bekannten Verbindungen und Mischungen, wie Phosphonium-, Sulfonium- und Jodoniumsalze, Halogenverbindungen und Organometall-Organohalogen-Kombinationen geeignet.

Die genannten Phosphonium-, Sulfonium- und Jodoniumverbindungen werden in der Regel eingesetzt in Form ihrer in organischen Lösemitteln löslichen Salze, meist als Abscheidungsprodukt mit komplexen Säuren wie Borfluorwasserstoffsäure, Hexafluorphosphor-, Hexafluorantimon- und -arsensäure.

Grundsätzlich sind als halogenhaltige strahlungsempfindliche und Halogenwasserstoffsäure bildende Verbindungen alle auch als photochemische Radikalstarter bekannten organischen Halogenverbindungen, beispielsweise solche mit mindestens einem Halogenatom an einem Kohlenstoffatom oder an einem aromatischen Ring brauchbar (US-A 3 515 552). Von diesen Verbindungen werden die s-Triazinderivate mit Halogenmethylgruppen, insbesondere Trichlormethylgruppen und einem aromatischen bzw. ungesättigten Substituenten im Triazinkern, wie sie in DE-C 27 18 259, entsprechend US-A 4 189 323, beschrieben sind, bevorzugt. Ebenso geeignet sind 2-Trihalogenmethyl-1,3,4-oxdiazole. Die Wirkung dieser halogenhaltigen Verbindungen kann auch durch bekannte Sensibilisatoren spektral beeinflußt und gesteigert werden.

Beispiele für geeignete photochemische Säurespender sind:

4-Methyl-6-trichlormethyl-2-pyron, 4-(3,4,5-Trimethoxy-styryl)-6-trichlormethyl-2-pyron, 4-(4-Methoxy-styryl)-6-(3,3,3-trichlorpropenyl)-2-pyron, 2-Trichlormethyl-benzimidazol, 2-Tribrommethylchinolin, 2,4-Dimethyl-1-tribromacetyl-benzoesäure, 1,4-Bis-dibrommethyl-benzol, Tris-dibrommethyl-s-triazin, 2-(6-Methoxy-naphth-2-yl)-, 2-(Naphth-1-yl)-, 2-(4-Ethoxyethylnaphth-1-yl)-, 2-(Benzo-pyran-3-yl)-, 2-(4-Methoxyanthrac-1-yl)-, 2- (4-Styrylphenyl)-, 2-(Phenanthr-9-yl)-4,6-bis-trichlormethyl-s-triazin und die in den Beispielen aufgeführten Verbindungen.

Die Menge des photochemischen Säurespenders kann, je nach seiner chemischen Natur und der Zusammensetzung der Schicht, ebenfalls sehr verschieden sein. Günstige Ergebnisse werden erhalten mit etwa 0,5 bis zu 20 Gewichtsprozent, bezogen auf den Gesamtfeststoff. Besonders für lichtempfindliche Schichten von Dicken über 0,01 mm empfiehlt es sich, relativ wenig Säurespender zu verwenden.

Zusätzlich können noch zahlreiche andere Oligomere und Polymerisate mitverwendet werden, z.B. Phenolharze vom Novolaktyp oder Vinylpolymerisate wie Polyvinylacetale, Polymethacrylate, Polyacrylate, Polyvinylether und Polyvinylpyrrolidone, die selbst durch Comonomere modifiziert sein können.

Der günstigste Anteil an diesen Zusätzen richtet sich nach den anwendungstechnischen Erfordernissen

und dem Einfluß auf die Entwicklungsbedingungen und beträgt im allgemeinen nicht mehr als 20 Gewichtsprozent vom erfindungsgemäß eingesetzten Polymerisat. In geringen Mengen kann die strahlungsempfindliche Schicht für spezielle Erfordernisse wie Flexibilität, Haftung, Glanz etc. außerdem noch Substanzen wie Polyglykole, Celluloseether, z.B. Ethylcellulose, Netzmittel und feinteilige Pigmente enthalten.

Ferner können dem strahlungsempfindlichen Gemisch noch lösliche oder auch feinteilige dispergierbare Farbstoffe sowie, je nach Anwendungszweck, auch UV-Absorber zugesetzt werden. Als Farbstoffe haben sich die Triphenylmethanfarbstoffe, insbesondere in der Form ihrer Carbinolbasen, besonders bewährt. Die günstigsten Mengenverhältnisse der Komponenten lassen sich im Einzelfall durch Vorversuche leicht ermitteln.

Die Erfindung betrifft auch ein strahlungsempfindliches Aufzeichnungsmaterial aus einem Schichtträger und einer aufgebrachten strahlungsempfindlichen Schicht, die ein Gemisch nach den Ansprüchen enthält.

Zur Beschichtung eines geeigneten Schichtträgers werden die Gemische im allgemeinen in einem Lösungsmittel gelöst. Die Wahl der Lösungsmittel ist auf das vorgesehene Beschichtungsverfahren, die Schichtdicke und die Trocknungsbedingungen abzustimmen. Geeignete Lösungsmittel für das erfindungsgemäße Gemisch sind Ketone, wie Methylethylketon, chlorierte Kohlenwasserstoffe, wie Trichlorethylen und 1,1,1-Trichlorethan, Alkohole, wie n-Propanol, Ether, wie Tetrahydrofuran, Alkoholether, wie Ethylenglykol-monoethylether und Ester, wie Butylacetat. Es können auch Gemische verwendet werden, die zudem noch für spezielle Zwecke Lösungsmittel, wie Acetonitril, Dioxan oder Dimethylformamid enthalten können. Prinzipiell sind alle Lösungsmittel verwendbar, die mit den Schichtkomponenten nicht irreversibel reagieren. Partialether von Glykolen, insbesondere Ethylenglykolmonomethylether und Propylenglykolmonomethylether allein oder im Gemisch werden besonders bevorzugt.

Als Schichtträger für Schichtdicken unter ca. 10 µm werden meist Metalle verwendet. Für Offsetdruckplatten können eingesetzt werden: walzblankes, mechanisch und/oder elektrochemisch aufgerauhtes und gegebenenfalls anodisiertes Aluminium, das zudem noch chemisch, z.B. mit Polyvinylphosphonsäure, Silikaten, Phosphaten, Hexafluorzirkonaten oder mit hydrolysiertem Tetraethylorthosilikat vorbehandelt sein kann.

Die Beschichtung des Schichtträgers erfolgt in bekannter Weise durch Aufschleudern, Sprühen, Tauchen, Walzen, mittels Breitschlitzdüsen, Rakeln oder durch Gießer-Antrag.

Zum Belichten können die üblichen Lichtquellen wie Röhrenlampen, Xenonimpulslampen, metallhalogeniddotierte Quecksilberdampf-Hochdrucklampen und Kohlebogenlampen verwendet werden.

Unter Belichtung bzw. Bestrahlung ist in dieser Beschreibung die Einwirkung aktinischer elektromagnetischer Strahlung in Wellenlängenbereichen unterhalb etwa 500 nm zu verstehen. Alle in diesem Wellenlängenbereich emittierenden Strahlungsquellen sind prinzipiell geeignet.

Mit Vorteil können auch Laserbestrahlungsgeräte, insbesondere automatische Verarbeitungsanlagen verwendet werden, die als Strahlungsquelle, z.B. einen Argon- oder Krypton-Ionen-Laser enthalten.

Die Bestrahlung kann ferner mit Elektronenstrahlen erfolgen. In diesem Falle können auch im üblichen Sinne nicht lichtempfindliche Säure bildende Verbindungen als Initiatoren der Solubilisierungsreaktion eingesetzt werden, z.B. halogenierte aromatische Verbindungen oder halogenierte polymere Kohlenwasserstoffe. Auch Röntgenstrahlen können zur Bilderzeugung verwendet werden.

Die bildmäßig belichtete oder bestrahlte Schicht kann in bekannter Weise mit praktisch den gleichen Entwicklern, wie sie für handelsübliche Naphthochinondiazid-Schichten und Kopierlacke bekannt sind, entfernt werden, oder die erfindungsgemäßen Materialien können in ihrem Kopierverhalten mit Vorteil auf die bekannten Hilfsmittel wie Entwickler und programmierte Sprühentwicklungsgeräte abgestimmt werden. Die wäßrigen Entwicklerlösungen können zum Beispiel Alkaliphosphate, -silikate oder -hydroxide und ferner Netzmittel sowie gegebenenfalls kleinere Anteile organischer Lösungsmittel enthalten. In bestimmten Fällen sind auch Lösungsmittel-Wasser-Gemische als Entwickler brauchbar. Die Wahl des günstigsten Entwicklers kann durch Versuche mit der jeweils verwendeten Schicht ermittelt werden. Bei Bedarf kann die Entwicklung mechanisch unterstützt werden.

Insbesondere kann das erfindungsgemäße Aufzeichnungsmaterial in einem Verfahren zur Herstellung von chemikalien- und wärmebeständigen Reliefaufzeichnungen verwendet werden, bei dem man ein strahlungsempfindliches Aufzeichnungsmaterial aus einem Schichtträger und einer strahlungsempfindlichen Schicht bildmäßig belichtet, mit einer wäßrig-alkalischen Entwicklerlösung entwickelt und das erhaltene Reliefbild - gegebenenfalls mit einem hydrophilen Schutzfilm überzogen - auf erhöhte Temperatur erwärmt.

Das Verfahren ist dadurch gekennzeichnet, daß man ein strahlungsempfindliches Aufzeichnungsmaterial nach Anspruch 14 verwendet und die entwickelte Schicht 0,5 bis 60 Minuten auf eine Temperatur im Bereich von 150 bis 280 °C erwärmt.

Im Falle von Flachdruckplatten wird vorzugsweise eine Erwärmungszeit im unteren Bereich, etwa von 0,5 bis 6 Minuten, und im Falle von Photoresists eine Erwärmungszeit im oberen Bereich, etwa von 10 bis 60 Minuten angewendet.

Durch die Erfindung wird erreicht, daß nunmehr strahlungsempfindliche Gemische und Aufzeichnungsmaterialien zur Verfügung stehen, die eine gute Lichtempfindlichkeit und ein einwandfreies Entwicklungsverhalten besitzen, mit denen in hoher Auflage gedruckt werden kann, die bei der Verwendung als Photoresist einen hervorragenden Wärmestand aufweisen, die inbesondere thermisch nachgehärtet werden können und nach der Nachhärtung gegenüber den bekannten Materialien eine bessere Chemikalienbeständigkeit besitzen.

Im folgenden werden Beispiele für bevorzugte Ausführungsformen angegeben. In den Beispielen stehen Gewichtsteile (Gt) und Volumenteile (Vt) im Verhältnis von g zu ccm. Prozent- und Mengenverhältnisse sind, wenn nichts anderes angegeben ist, in Gewichtseinheiten zu verstehen.

Tabelle 1:

| Monomer Nr. | Bezeichnung | entspr. Formel |
|---|---|---|
| 1 | N-(4-Hydroxyphenyl)methacrylamid | I |
| 2 | 2-Hydroxyphenylmethacrylat | I |
| 3 | 2,3-Dihydroxyphenylmethacrylat | I |
| 4 | 4-Hydroxystyrol | I |
| 5 | Gemisch aus 3- und 4-Chlormethylstyrol (60/40) | II |
| 6 | Gemisch aus 3- und 4-Brommethylstyrol (60/40) | II |
| 7 | Chloressigsäurevinylester | II |
| 8 | Chlormethylmethacrylat | II |
| 9 | 2-Chlorethylmethacrylat | II |
| 10 | N(2,2,2-Trichlor-1-hydroxyethyl)acrylamid | II |
| 11 | 3-Chlor-2-hydroxypropylmethacrylat | II |
| 12 | 3-Chlormethyl-4-hydroxystyrol | III |
| 13 | Isomerengemisch verschiedener Chlormethyl-2-hydroxyphenylmethacrylate | III |
| 14 | Isomerengemisch verschiedener Chlormethyl-2,3-dihydroxyphenylmethacrylate | III |
| 15 | Styrol | - |
| 16 | Methylstyrol | - |
| 17 | Furfurylmethacrylat | - |
| 18 | N-Methoxymethylmethacrylamid | - |
| 19 | N,N'-Methylen-bismethacrylamid | - |

**Tabelle 2:**

Polymerisate

| Polymer Nr. | Monomer 1[Mol%] | Monomer 2[Mol%] | Monomer 3[Mol%] | $M_W$ | $\frac{mmol\ OH}{g}$ | $\frac{mmol\ CH_{3-n}Xn}{g}$ | Bemerkung |
|---|---|---|---|---|---|---|---|
| 1 | 1 (85) | 18 (15) | - | 20.000 | 5,0 | - | Vergleich (EP 184 044) |
| 2 | 1 (") | 5 (") | - | 18.000 | 4,9 | 0,87 | |
| 3 | 2 (") | 18 (") | - | 20.000 | 5,0 | - | Vergleich |
| 4 | 2 (") | 5 (") | - | 18.000 | 4,9 | 0,86 | |
| 5 | 3 (") | 18 (") | - | 19.000 | 9,2 | - | Vergleich |
| 6 | 3 (") | 5 (") | - | 17.000 | 9,1 | 0,80 | |
| 7 | 4 (") | 18 (") | - | 23.000 | 7,0 | - | Vergleich |
| 8 | 4 (") | 5 (") | - | 20.000 | 6,8 | 1,20 | |
| 9 | 2 (65) | 5 (15) | 15 (20) | 18.000 | 4,1 | 0,94 | |
| 10 | 2 (") | 6 (") | " " | 14.000 | 3,9 | 0,90 | |
| 11 | 2 (") | 7 (") | " " | 13.000 | 4,2 | 0,97 | |
| 12 | 2 (") | 8 (") | " " | 13.000 | 4,1 | 0,96 | |
| 13 | 2 (") | 9 (") | " " | 19.000 | 4,1 | 0,94 | |

**Fortsetzung Tabelle 2:**

Polymerisate

| Polymer Nr. | Monomer 1 [Mol%] | Monomer 2 [Mol%] | Monomer 3 [Mol%] | $M_W$ | mmol OH / g | mmol $CH_{3-n}X_n$ / g | Bemerkung |
|---|---|---|---|---|---|---|---|
| 14 | 2 (65) | 10 (15) | 15 (20) | 13.000 | 3,8 | 0,89 | |
| 15 | 2 (") | 11 (") | " " | 19.000 | 4,0 | 0,92 | |
| 16 | 2 (") | 11 (") | 16 " | 18.000 | 3,9 | 0,90 | |
| 17 | 2 (") | 11 (") | 17 " | 18.000 | 4,0 | 0,92 | |
| 18 | 2 (85) | 11 (13) | 18 (2) | 19.000 | 4,8 | 0,73 | |
| 19 | 2 (85) | 11 (13) | 18 (2) | 19.000 | 4,8 | 0,79 | |
| 20 | 2 (85) | 11 (13) | 19 (2) | 134.000 | 4,8 | 0,73 | Vergleich |
| 21 | 14 (15) | 3 (85) | - | 20.000 | 9,9 | 0,75 | |
| 22 | 13 (15) | 2 (85) | - | 18.000 | 5,4 | 0,81 | |
| 23 | 12 (15) | 4 (85) | - | 22.000 | 7,8 | 1,18 | |
| 24 | 12 (12) | 4 (88) | - | 22.000 | 7,9 | 0,85 | |
| 25 | 12 ( 9) | 4 (91) | - | 22.000 | 8,0 | 0,72 | |
| 26 | 12 ( 6) | 4 (94) | - | 21.000 | 8,1 | 0,49 | |
| 27 | 12 ( 3) | 4 (97) | - | 21.000 | 8,2 | 0,25 | |
| 28 | - | 4 (100) | - | 21.000 | 8,3 | 0,0 | Vergleich |
| 29 | Kresol-Formaldehyd-Novolak | | | 6.000 | 5,7 | - | Vergleich |

## Beispiel 1

Eine in Salzsäure elektrolytisch aufgerauhte, in Schwefelsäure anodisierte und mit Polyvinylphosphonsäure hydrophilierte Aluminiumplatte wird mit folgender Lösung schleuderbeschichtet:

7,0 Gt (Gewichtsteile) Bindemittel (vgl. Tabelle 3),

| | |
|---|---|
| 1,5 Gt | eines Veresterungsproduktes aus 3 Mol 1,2-Naphthochinon-(2)-diazid-5-sulfonylchlorid und 1 Mol 2,3,4-Trihydroxybenzophenon, |
| 0,2 Gt | 1,2-Naphthochinon-(2)-diazid-4-sulfonylchlorid, |
| 0,08 Gt | Victoriareinblau (C.I. 44 045), |
| 100 Gt | eines Lösungsmittelgemisches aus Tetrahydrofuran und Propylenglykolmonomethylether (55:45). |

Nach 2-minütigem Trocknen bei 100 °C resultiert eine Schichtdicke von 2 µm.

Prüfung der Lichtempfindlichkeit:

Die jeweiligen Druckplatten werden unter einer 5-kW-Metallhalogenidlampe im Abstand von 110 cm durch einen Halbtonstufenkeil mit 13 Dichtestufen von je 0,15 (Belichtungskeil "BK 01" der Hoechst AG) 60 Sekunden (s) lang belichtet und 60 Sekunden lang in einem der folgenden Entwickler entwickelt:

Entwickler A:

| | |
|---|---|
| 8,5 Gt | $Na_2SiO_3$ x 9 $H_2O$, |
| 0,8 Gt | NaOH und |
| 1,5 Gt | $Na_2B_4O_7$ x 10 $H_2O$ in |
| 89,2 Gt | $H_2O$. |

Entwickler B:

| | |
|---|---|
| 5,3 Gt | Natriummetasilikat x 9 $H_2O$, |
| 3,4 Gt | Trinatriumphosphat x 12 $H_2O$, |
| 0,3 Gt | Natriumhydrogenphosphat (wasserfrei), |
| 91,0 Gt | Wasser. |

Entwickler C:

Mischung aus

| | |
|---|---|
| 50,0 Gt | Entwickler B und |
| 50,0 Gt | $H_2O$. |

Die Lichtempfindlichkeit wird an Hand der Stufe 3 des Halbtonstufenkeils beurteilt: offen = bereits frei von Kopierschicht, nicht offen = Kopierschichtreste noch vorhanden.

Prüfung des thermischen Vernetzungsverhaltens: Die Platten werden anschließend halbseitig ausbelichtet und 5 Minuten bei 230 °C in einem Lacktrockenschrank eingebrannt. Mit Dimethylformamid wird die Chemikalienresistenz der eingebrannten Platten in den unbelichteten und ausbelichteten Partien geprüft (+ = kein Angriff; - = Angriff).

Prüfung des Aufentwicklungsverhaltens:

Die belichteten Platten werden 15 Sekunden lang entwikkelt und dann mit handelsüblicher schwarzer Offsetfarbe eingefärbt. Beurteilt wird das Auftreten von Ton in den bildfreien Partien.

Von einer Reihe dieser Platten wurden im nicht thermisch gehärteten Zustand Druckversuche in einer Bogenoffsetmaschine durchgeführt. Tabelle 4 gibt die Ergebnisse wieder.

Tabelle 3:

| Bsp. Nr. | Bindemittel (aus Tab.2) | Wertung (e=Erfindung Formel) | Entwickler | Halbton stufe 3 | Aufentwicklung | Chemikalienresistenz nach Einbrennen unbelichtet | belichtet |
|---|---|---|---|---|---|---|---|
| 1 - 1 | 1 | Vergleich | A | offen | tont | + | + |
| 1 - 2 | 2 | e: I + II | A | " | tonfrei | + | + |
| 1 - 3 | 3 | Vergleich | A | " | tont | + | + |
| 1 - 4 | 4 | e: I + II | A | " | tonfrei | + | + |
| 1 - 5 | 5 | Vergleich | C | " | tont | + | + |
| 1 - 6 | 6 | e: I + II | C | " | tonfrei | + | + |
| 1 - 7 | 7 | Vergleich | B | " | tont | + | + |
| 1 - 8 | 8 | e: I + II | B | " | tonfrei | + | + |
| 1 - 9 | 21 | e: III | C | " | " | + | + |
| 1 - 10 | 22 | e: III | A | " | " | + | + |
| 1 - 11 | 23 | e: III | B | " | " | + | + |
| 1 - 12 | 29 | Vergleich | A | " | " | + | + |

Tabelle 4:

| Beispiel | Polymer | Druckauflage |
|---|---|---|
| 1 - 2 e | 2 | 150.000 |
| 1 - 4 e | 4 | 160.000 |
| 1 - 6 e | 6 | 160.000 |
| 1 - 8 e | 8 | 150.000 |
| 1 - 10 e | 22 | 140.000 |
| 1 - 12 (Vergleich) | 29 | 90.000 |

Die Ergebnisse zeigen, daß mit erfindungsgemäßen Polymerisaten hergestellte Druckplattenkopierschichten eine höhere Druckauflage als herkömmliche Positivkopierschichten mit Novolaken als Bindemittel ergeben, daß sie durch thermische Nachhärtung auch in vorbelichteten Bereichen resistent gegen aggressive Chemikalien werden, und daß sie bezüglich Lichtempfindlichkeit und Aufentwicklung keine Nachteile aufweisen.

**Beispiel 2**

Eine in Salzsäure elektrolytisch aufgerauhte, in Schwefelsäure anodisierte und mit Polyvinylphosphonsäure hydrophilierte Aluminiumplatte wird mit folgender Lösung schleuderbeschichtet:

| | |
|---|---|
| 7,0 Gt | Bindemittel (vgl. Tabelle 5), |
| 1,5 Gt | eines Veresterungsproduktes aus 3 Mol 1,2-Naphthochinon-(2)-diazid-4-sulfonylchlorid und 1 Mol 2,3,4-Trihydroxybenzophenon, |
| 0,2 Gt | 1,2-Naphthochinon-(2)-diazid-4-sulfonylchlorid, |
| 0,08 Gt | Victoriareinblau (C.I. 44 045), |
| 100 Gt | eines Lösungsmittelgemisches aus Tetrahydrofuran und Propylenglykolmonomethylether (55:45). |

Nach 2-minütigem Trocknen bei 100 °C resultiert eine Schichtdicke von 2 µm.

Die Prüfung der Lichtempfindlichkeit, des thermischen Vernetzungsverhaltens und des Aufentwicklungsverhaltens erfolgte wie in Beispiel 1 beschrieben.

Tabelle 5 gibt die Ergebnisse wieder.

Die Beispiele zeigen 1) die Eignung von erfindungsgemäßen Polymerisaten, welche aus unterschiedlichen Einheiten entsprechend Formel II aufgebaut sind und 2) daß Polymerisate mit einem Molekulargewicht von >100 000 nicht mehr ausreichend schnell aufentwickelbar sind.

**Tabelle 5:**

| Bsp. Nr. | Bindemittel (aus Tab.2) | Wertung (e=Erfindung Formel) | Entwickler | Halbton stufe 3 | Aufentwicklung | Chemikalienresistenz nach Einbrennen unbelichtet | belichtet |
|---|---|---|---|---|---|---|---|
| 2 - 1 | 9 | e | A | offen | tonfrei | + | + |
| 2 - 2 | 10 | e | A | " | " | + | + |
| 2 - 3 | 11 | e | A | " | " | + | + |
| 2 - 4 | 12 | e | A | " | " | + | + |
| 2 - 5 | 12 | e | A | " | " | + | + |
| 2 - 6 | 14 | e | A | " | " | + | + |
| 2 - 7 | 15 | e | A | " | " | + | + |
| 2 - 8 | 16 | e | A | " | " | + | + |
| 2 - 9 | 17 | e | A | " | " | + | + |
| 2 - 10 | 18 | e | A | " | noch frei | + | + |
| 2 - 11 | 19 | e | A | " | " " | + | + |
| 2 - 12 | 20 | Vergleich | A | " | tont | + | + |

**Beispiel 3**

Eine in Salzsäure elektrolytisch aufgerauhte in Schwefelsäure anodisierte und mit Polyvinylphosphonsäure hydrophilierte Aluminiumplatte wird mit folgender Lösung schleuderbeschichtet:

| | |
|---|---|
| 5,0 Gt | Bindemittel (vgl. Tabelle 6), |
| 0,5 Gt | eines Veresterungsproduktes aus 3 Mol 1,2-Naphthochinon-(2)-diazid-4-sulfonylchlorid und 1 Mol 2,3,4-Trihydroxybenzophenon, |
| 1,4 Gt | eines oligomeren Acetals, welches durch Polykondensation von Triethylenglykol und 2-Ethylbutyraldehyd erhalten wurde, Hydroxylzahl 140, |
| 0,2 Gt | 2-(4-Styrylphenyl)-4,6-bistrichlormethyl-s-triazin, |
| 0,03 Gt | Kristallviolett-Base (C.I. 42 555:1), |
| 100 Gt | eines Lösungsmittelgemisches aus Tetrahydrofuran und Propylenglykolmonomethylether (55:45). |

Nach 2-minütigem Trocknen bei 100 °C resultiert eine Schichtdicke von 2 µm.

Auf diese Kopierschicht wird dann eine nicht lichtempfindliche Deckschicht aus Polyvinylalkohol (K-Wert 4, Restacetylgruppengehalt 12 %) entsprechend DE-A 37 15 790 aus Wasser in einer Stärke von 0,2 µm aufgebracht.

Die Platten werden unter einer Vorlage wie in Beispiel 1 25 Sekunden lang belichtet, 1 Minute lang auf 80 °C erwärmt und dann entwickelt. Lichtempfindlichkeit, Aufentwicklung und thermisches Vernetzungsverhalten werden, wie in Beispiel 1, geprüft. Die Deckschicht wird vor der thermischen Härtung mit $H_2O$ abgewaschen.

**Tabelle 6:**

| Bsp. Nr. | Bindemittel (aus Tab.2) | Wertung (e=Erfindung Formel) | Entwickler | Halbton stufe 3 | Aufentwicklung | Chemikalienresistenz nach Einbrennen unbelichtet | belichtet |
|---|---|---|---|---|---|---|---|
| 3 - 1 | 23 | e | B | offen | tonfrei | + | + |
| 3 - 2 | 24 | e | B | " | " | + | + |
| 3 - 3 | 25 | e | B | " | " | + | + |
| 3 - 4 | 26 | e | B | " | " | + | + |
| 3 - 5 | 27 | e | B | " | " | + | + |
| 3 - 6 | 28 | Vergleich | B | " | " | - | - |

Die Ergebnisse zeigen, daß der Gehalt an vernetzungsbefähigten $-CH_{3-n}X_n$ Einheiten im Polymerisat über 0,1 mmol/g Polymer liegen muß, um eine Chemikalienresistenz des vernetzten Films zu gewährleisten.

**Beispiel 4**

Zur Herstellung eines Positivtrockenresists werden Beschichtungslösungen hergestellt aus:

| | |
|---|---|
| 40,0 Gt | Bindemittel (vgl. Tabelle 3), |
| 10,0 Gt | einer Verbindung mit säurespaltbaren C-O-C-Einheiten (Tabelle 7), |
| 0,5 Gt | eines photochemischen Säurebildners (Tabelle 7), |
| 6,0 Gt | Polyethylacrylat, |
| 0,01 Gt | Kristallviolett-Base (C.I. 42 555:1), |
| 100 Gt | Butanon. |

Die Lösungen werden jeweils auf 26 µm dicke, biaxial gestreckte und thermofixierte Polyethylenterephthalatfolien aufgeschleudert und anschließend 10 Minuten lang bei 100 °C im Umlufttrockenschrank nachgetrocknet. Die Umdrehungszahl der Schleuder wird so reguliert, daß sich eine Schichtdicke von 25 µm ergibt. Zum Schutz gegen Staub und Verkratzungen wird darauf noch eine Polyethylenfolie als Deckfolie kaschiert.

Zur Herstellung von Leiterplatten werden die Trockenresists nach Abziehen der Deckfolie in einem handelsüblichen Laminator auf einen gereinigten, vorgewärmten Träger, der aus einem Isoliermaterial mit ein- oder beidseitiger, 35 µm dicker Kupferauflage besteht, laminiert. Nach Abziehen der Trägerfolie und eventuellem Nachtrocknen wird unter einer Vorlage mit einer 5-kW-Metallhalogenidlampe in 110 cm Abstand 30 Sekunden lang belichtet und nach einer Wartezeit von 15 Minuten in 1 %iger Natronlauge 90 Sekunden lang entwickelt.

Die entstandenen Resistschablonen wurden über 30 Minuten lang bei 150 °C getempert und dann folgenden Prüfungen unterzogen:

| | |
|---|---|
| 1. Galvanoresistenz | (Aufbau von Pb/Sn-Legierung), |
| 2. Ätzresistenz | (ammoniakalische Cu(II)-Chloridlösung), |
| 3. Lösemittelresistenz | (achtstündiges Tauchen in Isopropanol). |

Die Ergebnisse sind in Tabelle 7 aufgezeigt. Folgende Verbindungen mit säurespaltbaren C-O-C-Einheiten wurden eingesetzt:

Nr. 1: polymerer Orthoester, hergestellt durch Kondensation von Orthoameisensäuretrimethylester mit 4-Oxa-6,6-bis-hydroxymethyloctan-1-ol,

Nr. 2: Polyacetal, hergestellt aus Triethylenglykol und 2-Ethylbutyraldehyd, Hydroxylzahl 140.

Folgende photochemischen Säurebildner wurden verwendet:

Nr. 1: 2-(4-Ethoxy-naphth-1-yl)-4,6-bis-trichlormethyl-s-triazin,

Nr. 2: 2-(4-Styrylphenyl)-4,6-bis-trichlormethyl-s-triazin.

**Tabelle 7:**

| Bsp. Nr. | Polymer | säurespaltbare Verbindung | photochem. Säurebildner | Galvano-resistenz | Ätz-resistenz | Lösungsmittel-resistenz |
|---|---|---|---|---|---|---|
| 4 - 1 | 2 | 1 | 1 | + | + | + |
| 4 - 2 | 2 | 1 | 2 | + | + | + |
| 4 - 3 | 2 | 2 | 1 | + | + | + |
| 4 - 4 | 2 | 2 | 2 | + | + | + |
| 4 - 5 | 4 | 2 | 2 | + | + | + |
| 4 - 6 | 23 | 2 | 2 | + | + | + |

**Beispiel 5**

Zur Prüfung des Einflusses einer Einbrenngummierung auf das thermische Vernetzungsverhalten wird mit den Druckplatten aus Beispiel 1 folgende Prüfung vorgenommen:

Nach Belichtung und Entwicklung der Druckplatten, wie in Beispiel 1 beschrieben, werden diese mit einer handelsüblichen Einbrenngummierung (RC 99 der HOECHST AG) manuell gummiert und dann 5 Minuten lang bei 230 °C in einem Trockenschrank eingebrannt. Nach Abspülen der Gummierung mit Wasser wird mit Dimethylformamid in der üblichen Weise die Chemikalienresistenz geprüft.

Die folgende Tabelle 8 gibt die Ergebnisse wieder.

Tabelle 8:

| Beispiel | Polymer (Tab.2) | Chemikalien-resistenz |
|---|---|---|
| 5-1 | 2 | + |
| 5-2 | 4 | + |
| 5-3 | 6 | + |
| 5-4 | 8 | + |
| 5-5 | 21 | + |
| 5-6 | 22 | + |
| 5-7 | 23 | + |

Es ist keinerlei Beeinträchtigung des thermischen Vernetzungsverhaltens der erfindungsgemäßen Polymerisate durch eine Einbrenngummierung festzustellen.

## Patentansprüche

1. Positiv arbeitendes strahlungsempfindliches Gemisch, das als wesentliche Bestandteile
   a) ein in Wasser unlösliches, in wäßrig-alkalischen Lösungen lösliches polymeres Bindemittel und
   b) ein 1,2-Chinondiazid und/oder eine Kombination aus
      1. einer unter Einwirkung von aktinischer Strahlung starke Säure bildenden Verbindung und
      2. einer Verbindung mit mindestens einer durch Säure spaltbaren C-O-C- Bindung

   enthält, dadurch gekennzeichnet, daß als polymeres Bindemittel ein Polymerisat mit einem Molekulargewicht zwischen 5000 und 100000, einem Gehalt an phenolischen Hydroxylgruppen von etwa 1 bis 15 mmol/g Polymerisat und einem Gehalt an $-CH_{3-n}X_n$ Einheiten von mindestens 0,1 mmol/g Polymerisat, worin X für Halogen und n für 1, 2 oder 3 stehen, vorhanden ist.

2. Gemisch nach Anspruch 1, dadurch gekennzeichnet, daß das polymere Bindemittel ein Polymerisat mit einem Gehalt von etwa 2 bis 10 mmol/g an phenolischen Hydroxylgruppen und einem Gehalt von etwa 0,5 bis 2 mmol/g an $-CH_{3-n}X_n$ Einheiten darstellt.

3. Gemisch nach Anspruch 1 oder 2, dadurch gekennzeichnet, daß das polymere Bindemittel ein Copolymerisat ist und
   a) Einheiten der Formel I

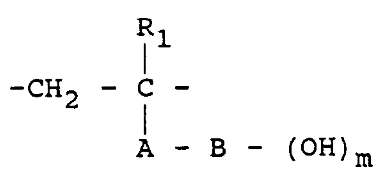

I

worin

$R_1$ Wasserstoff oder ($C_1$-$C_4$)-Alkyl,

A eine Einfachbindung oder eine Konfiguration $A_1$ aus der Reihe
-K-,

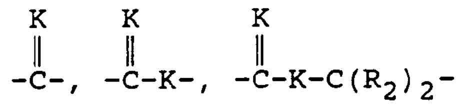

oder $-K-C(R_2)_2-$
mit
K für -O-, -S- oder $-NR_2-$ und
$R_2$ Wasserstoff oder $(C_1-C_4)$-Alkyl oder $(C_1-C_4)$-Alkylen,
B ein gegebenenfalls durch Alkyl, Alkoxy, Halogen oder Aryl substituiertes ein- oder zweikerniges carbocyclisches aromatisches Ringsystem und
m 1 oder 2
bedeuten und
b) Einheiten der allgemeinen Formel II

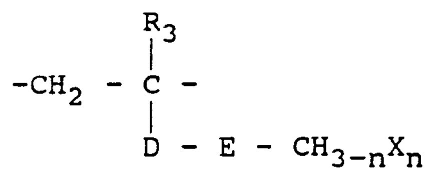

II

worin
$R_3$ Wasserstoff oder $(C_1-C_4)$-Alkyl,
D eine Einfachbindung, $(C_1-C_4)$-Alkylen oder die Konfiguration $A_1$,
E eine Einfachbindung, $(C_1-C_4)$-Alkylen, $(C_1-C_4)$-Hydroxyalkylen oder B,
X Halogen und
n 1, 2 oder 3
bedeuten, enthält.

**4.** Gemisch nach Anspruch 3, dadurch gekennzeichnet, daß das Copolymerisat Einheiten der allgemeinen Formel I mit
$R_1$ Wasserstoff oder Methyl
A die Konfiguration $A_1$

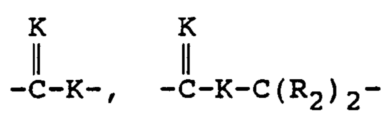

mit
K für -O-, oder $-NR_2-$ und
$R_2$ Wasserstoff,
B Phenyl und
m 1 oder 2
und Einheiten der allgemeinen Formel II mit
$R_3$ Wasserstoff oder Methyl,
D eine Einfachbindung oder die Konfiguration
-K-,

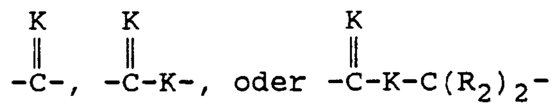

mit

K für -O- oder $-NR_2-$ und

$R_2$ Wasserstoff,

E eine Einfachbindung, $(C_1-C_2)$-Alkylen, $(C_1-C_2)$-Hydroxyalkylen oder Phenyl,

X Chlor oder Brom und

n 1, 2 oder 3

besitzt.

5. Gemisch nach Anspruch 1 oder 2, dadurch gekennzeichnet, daß das polymere Bindemittel ein Homo- oder Copolymerisat ist mit Einheiten der allgemeinen Formel III

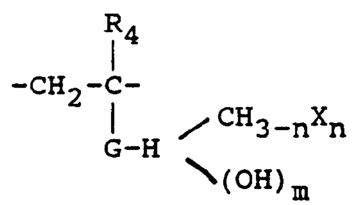

III

worin

$R_4$ Wasserstoff oder $(C_1-C_4)$-Alkyl,

G eine Einfachbindung, $(C_1-C_4)$-Alkylen oder die Konfiguration

$G_1$ aus der Reihe

-F-,

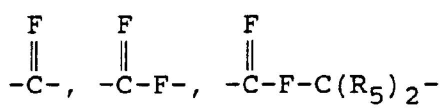

oder $-F-C(R_5)_2-$

mit

F für -O-, -S- oder $-NR_5-$ und

$R_5$ Wasserstoff, $(C_1-C_4)$-Alkyl oder $(C_1-C_4)$-Alkylen,

H ein gegebenenfalls durch Alkyl, Alkoxy, Halogen oder Aryl substituiertes ein- oder zweikerniges carbocyclisches aromatisches Ringsystem,

X Halogen,

m 1 oder 2 und

n 1, 2 oder 3

bedeuten.

6. Gemisch nach Anspruch 5, dadurch gekennzeichnet, daß das Homo- oder Copolymerisat Einheiten der allgemeinen Formel III mit

$R_4$ Wasserstoff oder Methyl,

G eine Einfachbindung oder die Konfiguration

$G_1$

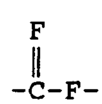

mit F für -O-,
H Phenyl,
X Chlor,
m 1 oder 2 und
n 1
besitzt.

7. Gemisch nach Ansprüchen 1 bis 6, dadurch gekennzeichnet, daß als polymeres Bindemittel ein Copolymerisat vorhanden ist, das Einheiten nach den allgemeinen Formeln I, II und III enthält.

8. Gemisch nach Ansprüchen 1 bis 6, dadurch gekennzeichnet, daß als polymeres Bindemittel ein Copolymerisat vorhanden ist, das Einheiten nach den allgemeinen Formeln I und II und/oder III enthält oder daraus besteht.

9. Gemisch nach Ansprüchen 1 bis 8, dadurch gekennzeichnet, daß X Chlor, Brom oder Jod bedeutet.

10. Gemisch nach Anspruch 9, dadurch gekennzeichnet, daß X Chlor bedeutet.

11. Gemisch nach Ansprüchen 1 bis 6, worin n gleich 1 ist.

12. Gemisch nach Ansprüchen 3 bis 6, worin m gleich 1 ist.

13. Gemisch nach Ansprüchen 3 bis 6, dadurch gekennzeichnet, daß als carbocyclisches aromatisches Ringsystem ein Benzolkern vorhanden ist.

14. Strahlungsempfindliches Aufzeichnungsmaterial aus einem Schichtträger und einer aufgebrachten strahlungsempfindlichen Schicht, die ein Gemisch nach Ansprüchen 1 bis 13 enthält.

15. Verfahren zur Herstellung von chemikalien- und wärmebeständigen Reliefaufzeichnungen, bei dem man ein strahlungsempfindliches Aufzeichnungsmaterial aus einem Schichtträger und einer strahlungsempfindlichen Schicht bildmäßig belichtet, mit einer wäßrig-alkalischen Entwicklerlösung entwickelt und das erhaltene Reliefbild - gegebenenfalls mit einem hydrophilen Schutzfilm überzogen - auf erhöhte Temperatur erwärmt, dadurch gekennzeichnet, daß man ein strahlungsempfindliches Aufzeichnungsmaterial nach Anspruch 14 verwendet, und die entwickelte Schicht 0,5 bis 60 Minuten auf eine Temperatur im Bereich von 150 bis 280 °C erwärmt.

## Claims

1. A positive-working radiation-sensitive mixture which contains
   a) a water-insoluble polymeric binder which is soluble in aqueous alkaline solutions, and
   b) a 1,2-quinone diazide and/or a combination of
      1. a compound which forms strong acid when exposed to actinic radiation and
      2. a compound containing at least one acid-cleavable C-O-C bond

   as essential constituents, wherein a polymer having a molecular weight of between 5,000 and 100,000, a content of phenolic hydroxyl groups of about 1 to 15 mmol/g of polymer and a content of $-CH_{3-n}X_n$ units of at least 0.1 mmol/g of polymer, where X is halogen and n is 1, 2 or 3, is present as polymeric binder.

2. A mixture as claimed in claim 1, wherein the polymeric binder is a polymer having a content of about 2 to 10 mmol/g of phenolic hydroxyl groups and a content of about 0.5 to 2 mmol/g of $-CH_{3-n}X_n$ units.

3. A mixture as claimed in claim 1 or 2, wherein the polymeric binder is a copolymer and contains
   a) units of the formula I

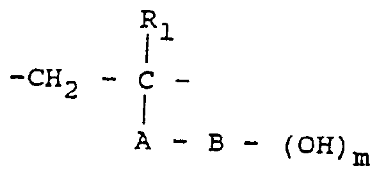

I

in which

- $R_1$ is hydrogen or $(C_1\text{-}C_4)$alkyl,
- A is a single bond or a configuration $A_1$ from the series comprising -K-

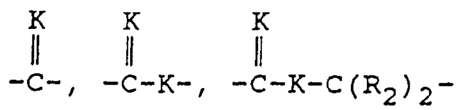

or $-K-C(R_2)_2-$

where

- K is -O-, -S- or $-NR_2-$ and
- $R_2$ is hydrogen or $(C_1\text{-}C_4)$alkyl or $(C_1\text{-}C_4)$alkylene,
- B is a monocyclic or bicyclic carbocyclic aromatic ring system, optionally substituted by alkyl, alkoxy, halogen or aryl, and
- m is 1 or 2,

and

b) units of the formula II

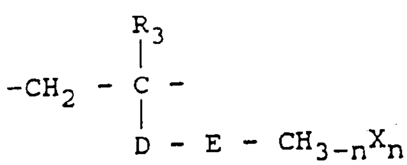

II

in which

- $R_3$ is hydrogen or $(C_1\text{-}C_4)$alkyl,
- D is a single bond, $(C_1\text{-}C_4)$alkylene or the configuration $A_1$,
- E is a single bond, $(C_1\text{-}C_4)$alkylene, $(C_1\text{-}C_4)$hydroxyalkylene or B,
- X is halogen, and
- n is 1, 2 or 3.

**4.** A mixture as claimed in claim 3, wherein the copolymer has units of the formula I with

- $R_1$ being hydrogen or methyl,
- A being the configuration $A_1$

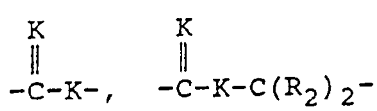

where

- K is -O- or $-NR_2-$ and
- $R_2$ is hydrogen,

B is phenyl and
m is 1 or 2,
and units of the formula II with
$R_3$ being hydrogen or methyl,
D being a single bond or the configuration
-K-,

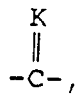 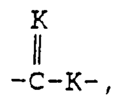 or 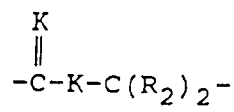

where
K is -O- or $-NR_2-$ and
$R_2$ is hydrogen,
E is a single bond, $(C_1-C_2)$alkylene, $(C_1-C_2)$hydroxyalkylene or phenyl,
X is chlorine or bromine, and
n is 1, 2 or 3.

**5.** A mixture as claimed in claim 1 or 2, wherein the polymeric binder is a homopolymer or copolymer containing units of the formula III

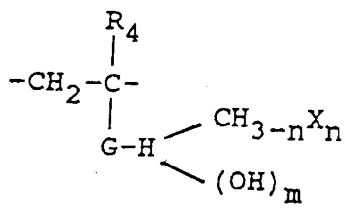

III

in which
$R_4$ being hydrogen or $(C_1-C_4)$alkyl
G being a single bond, $(C_1-C_4)$alkylene or the configuration $G_1$ from the series comprising
-F-,

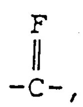 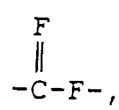 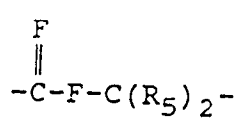

or $-F-C(R_5)_2-$
where
F is -O-, -S- or $-NR_5-$ and
$R_5$ is hydrogen, $(C_1-C_4)$alkyl or $(C_1-C_4)$alkylene,
H is a monocyclic or bicyclic carbocyclic aromatic ring system optionally substituted by alkyl, alkoxy, halogen or aryl,
X is halogen,
m is 1 or 2, and
n is 1, 2 or 3.

**6.** A mixture as claimed in claim 5, wherein the homopolymer or copolymer has units of the formula III with
$R_4$ is hydrogen or methyl,
G is a single bond or the configuration
$G_1$

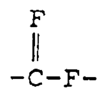

where F is -O-,
H is phenyl,
X is chlorine,
m is 1 or 2, and
n is 1.

7. A mixture as claimed in claims 1 to 6, wherein a copolymer which contains units of the formulae I, II and III is present as polymeric binder.

8. A mixture as claimed in claims 1 to 6, wherein a copolymer which contains units of the formulae I and II and/or III or is composed thereof is present as polymeric binder.

9. A mixture as claimed in claims 1 to 8, wherein X is chlorine, bromine or iodine.

10. A mixture as claimed in claim 9, wherein X is chlorine.

11. A mixture as claimed in claims 1 to 6, wherein n is equal to 1.

12. A mixture as claimed in claims 3 to 6, wherein m is equal to 1.

13. A mixture as claimed in claims 3 to 6, wherein a benzene nucleus is present as carbocyclic aromatic ring system.

14. A radiation-sensitive recording material comprising a layer base and a deposited radiation-sensitive layer which contains a mixture as claimed in claims 1 to 13.

15. A process for producing chemical-resistant and heat-resistant relief copies, in which process a radiation-sensitive recording material comprising a layer base and a radiation-sensitive layer is exposed imagewise and developed with an aqueous alkaline developer solution, and the relief image obtained - optionally coated with a hydrophilic protective film - is heated to an elevated temperature, which process comprises using a radiation-sensitive recording material as claimed in claim 14 and heating the developed layer for 0.5 to 60 minutes at a temperature in the range from 150 to 280°C.

## Revendications

1. Composition sensible aux radiations, travaillant en positif, qui contient en tant que composants essentiels
   a) un liant polymère insoluble dans l'eau, soluble dans des solutions aqueuses-alcalines et
   b) un 1,2-quinonediazide et/ou une association de
      1. un composé formant un acide fort sous l'effet d'un rayonnement actinique et
      2. un composé comportant au moins une liaison -C-O-C- pouvant être rompue par un acide,

   caractérisée en ce que, en tant que liant polymère, est présent un polymère ayant une masse moléculaire comprise entre 5 000 et 100 000, une teneur en groupes hydroxy phénoliques d'environ 1 à 15 mmoles/g de polymère et une teneur en motifs $-CH_{3-n}X_n$ d'au moins 0,1 mmole/g de polymère, motifs dans lesquels X représente un atome d'halogène et n est 1, 2 ou 3.

2. Composition selon la revendication 1, caractérisée en ce que le liant polymère représente un polymère ayant un teneur en groupes hydroxy phénoliques d'environ 2 à 10 mmoles/g et une teneur en motifs $-CH_{3-n}X_n$ d'environ 0,5 à 2 mmoles/g.

3. Composition selon la revendication 1 ou 2, caractérisée en ce que le liant polymère est un copolymère et contient
   a) des motifs de formule I

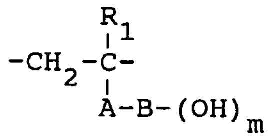

I

dans laquelle

$R_1$ représente un atome d'hydrogène ou un groupe alkyle en $C_1$-$C_4$,

A représente une liaison simple ou une configuration $A_1$ choisie parmi -K-,

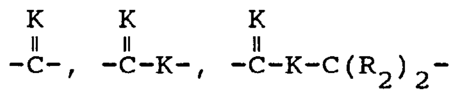

ou $-K-C(R_2)_2-$,

K representant -O-, -S- ou $-NR_2$ - et

$R_2$ représentant un atome d'hydrogène ou un groupe alkyle en $C_1$-$C_4$ ou alkylène en $C_1$-$C_4$,

B représente un système cyclique aromatique carbocyclique mono- ou binucléaire, éventuellement substitué par un atome d'halogène ou par un groupe alkyle, alcoxy ou aryle et

m est 1 ou 2,

et

b) des motifs de formule générale II

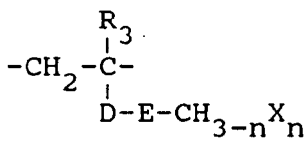

I

dans laquelle

$R_3$ représente un atome d'hydrogène ou un groupe alkyle en $C_1$-$C_4$,

D représente une liaison simple ou un groupe alkylène en $C_1$-$C_4$ ou la configuration $A_1$,

E représente une liaison simple ou un groupe alkylène en $C_1$-$C_4$, hydroxyalkylène en $C_1$-$C_4$ ou B,

X représente un atome d'halogène et

n est 1, 2 ou 3.

**4.** Composition selon la revendication 3, caractérisée en ce que le copolymère comporte des motifs de formule générale I dans lesquels

$R_1$ représente un atome d'hydrogène ou le groupe méthyle,

A représente la configuration $A_1$

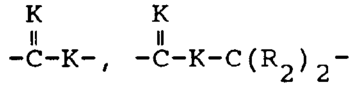

K représentant -O- ou $-NR_2$- et

$R_2$ étant un atome d'hydrogène,

B représente le groupe phényle et

m est 1 ou 2, et des motifs de formule générale II dans laquelle

$R_3$ représente un atome d'hydrogène ou le groupe méthyle,

D représente une liaison simple ou la configuration -K-,

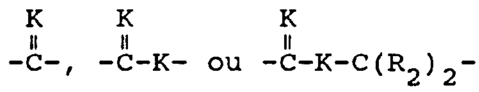

K représentant -O-, -S- ou $-NR_2$ - et

$R_2$ étant un atome d'hydrogène ,

E représente une liaison simple ou un groupe alkylène en $C_1$-$C_2$, hydroxyalkylène en $C_1$-$C_2$ ou phényle,

X est un atome de chlore ou de brome et

n est 1, 2 ou 3.

**5.** Composition selon la revendication 1 ou 2, caractérisée en ce que le liant polymère est un homo- ou copolymère à motifs de formule générale III

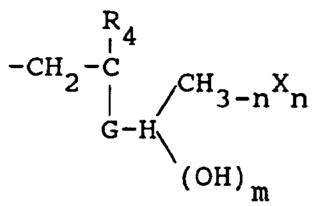

III

dans laquelle

$R_4$ représente un atome d'hydrogène ou un groupe alkyle en $C_1$-$C_4$,

G représente une liaison simple, un groupe alkylène en $C_1$-$C_4$ ou la configuration $G_1$ choisie parmi -F-,

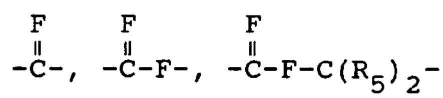

ou $-F-C(R_5)_2-$

F représentant -O-, -S- ou $-NR_5$- et

$R_5$ étant un atome d'hydrogène ou un groupe alkyle en $C_1$-$C_4$ ou alkylène en $C_1$-$C_4$,

H représente un système cyclique aromatique carbocyclique mono- ou binucléaire, éventuellement substitué par un atome d'halogène ou par un groupe alkyle, alcoxy ou aryle,

X représente un atome d'halogène,

m est 1 ou 2 et

n est 1, 2 ou 3.

**6.** Composition selon la revendication 5, caractérisée en ce que l'homo- ou copolymère comporte des motifs de formule générale III dans laquelle

$R_4$ représente un atome d'hydrogène ou le groupe méthyle,

G représente une liaison simple ou la configuration $G_1$

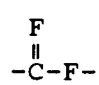

F représentant -O-,

H représente le groupe phényle,

X représente un atome de chlore,

m est 1 ou 2 et

n est 1.

**7.** Composition selon les revendications 1 à 6, caractérisée en ce que, en tant que liant polymère, est présent un copolymère qui contient des motifs selon les formules générales I, II et III.

**8.** Composition selon les revendications 1 à 6, caractérisée en ce que, en tant que liant polymère, est présent un copolymère qui contient des motifs selon les formules générales I et II et/ou III, ou consiste en ceux-ci.

**9.** Composition selon les revendications 1 à 8, caractérisée en ce que X représente le chlore, le brome ou l'iode.

**10.** Composition selon la revendication 9, caractérisée en ce que X représente le chlore.

**11.** Composition selon les revendications 1 à 6, dans laquelle n est égal à 1.

**12.** Composition selon les revendications 3 à 6, dans laquelle m est égal à 1.

**13.** Composition selon les revendications 3 à 6, caractérisée en ce que, en tant que système cyclique aromatique carbocyclique, est présent un noyau benzénique.

**14.** Matériau de reprographie sensible aux radiations, constitué d'un support de couche et d'une couche sensible aux radiations, appliquée, qui contient une composition selon les revendications 1 à 13.

**15.** Procédé pour l'obtention de reproductions en relief résistantes aux agents chimiques et à la chaleur, dans lequel un matériau de reprographie sensible aux radiations, composé d'un support de couche et d'une couche sensible aux radiations, est insolé selon l'image, développé avec une solution aqueuse-alcaline de développement, et l'image en relief obtenue - éventuellement revêtue d'une pellicule protectrice hydrophile - est chauffée à haute température, caractérisé en ce que l'on utilise un matériau de reprographie sensible aux radiations selon la revendication 14, et la couche développée est chauffée pendant 0,5 à 60 minutes, à une température dans la plage allant de 150 à 280°C.